(19) Europäisches Patentamt
European Patent Office
Office européen des brevets

(11) EP 4 656 684 A1

(12) **EUROPEAN PATENT APPLICATION**
published in accordance with Art. 153(4) EPC

(43) Date of publication:
**03.12.2025 Bulletin 2025/49**

(21) Application number: **24747263.2**

(22) Date of filing: **22.01.2024**

(51) International Patent Classification (IPC):
***C08L 83/04*** (2006.01) ***B32B 27/00*** (2006.01)
***C08G 77/44*** (2006.01) ***C08L 83/12*** (2006.01)
***C08L 101/06*** (2006.01) ***H01L 21/768*** (2006.01)
***H01L 23/532*** (2006.01)

(52) Cooperative Patent Classification (CPC):
**B32B 27/00; C08G 77/44; C08L 83/04; C08L 83/12; C08L 101/06; H01L 21/768; H01L 23/532**

(86) International application number:
**PCT/JP2024/001676**

(87) International publication number:
**WO 2024/157936 (02.08.2024 Gazette 2024/31)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **23.01.2023 JP 2023008162**

(71) Applicant: **Sekisui Chemical Co., Ltd.**
**Osaka-shi, Osaka 530-8565 (JP)**

(72) Inventors:
- **KUNISAWA, Tsukasa**
**Mishima-gun, Osaka 618-0021 (JP)**
- **SHIOJIMA, Taro**
**Mishima-gun, Osaka 618-0021 (JP)**
- **NOMOTO, Hayate**
**Mishima-gun, Osaka 618-0021 (JP)**
- **SHICHIRI, Tokushige**
**Mishima-gun, Osaka 618-0021 (JP)**
- **SATO, Kenichiro**
**Mishima-gun, Osaka 618-0021 (JP)**
- **DEGUCHI, Hidenobu**
**Mishima-gun, Osaka 618-0021 (JP)**

(74) Representative: **Cabinet Beau de Loménie**
**103, rue de Grenelle / CS 90800**
**75340 Paris Cedex 07 (FR)**

# (54) RESIN COMPOSITION, CURED FILM, LAMINATE, IMAGING DEVICE, SEMICONDUCTOR DEVICE, METHOD FOR MANUFACTURING LAMINATE, AND METHOD FOR MANUFACTURING ELEMENT HAVING BONDING ELECTRODE

(57) The present invention aims to provide a resin composition that excels in heat resistance and flexibility and can planarize bonding surfaces of elements even when the elements have irregularities on the surfaces, thus imparting high electrical connection reliability between the elements, as well as a cured film formed using the resin composition, a stack including the cured film, an imaging device including the stack, a semiconductor device including the stack, a method for producing the stack, and a method for producing an element including a bonding electrode for use in production of the stack. The resin composition of the present invention contains an organosilicon compound and a modifier, the modifier having a thermal weight loss of 10% or less between before and after being maintained at 400°C for three hours when the modifier alone is heated from room temperature to 300°C in the air at a temperature increase rate of 10°C/min, maintained for one hour, then heated to 400°C at a temperature increase rate of 10°C/min, and maintained at 400°C for three hours, a sample, prepared by adding the organosilicon compound and 1 part by weight of the modifier relative to 100 parts by weight of the organosilicon compound to ethyl benzoate such that the sample has a viscosity at 25°C of 45 cP, having a contact angle of 9° or greater and 20° or less on a silicon wafer when the sample is dropped onto the silicon wafer.

EP 4 656 684 A1

## Description

TECHNICAL FIELD

The present invention relates to a resin composition, a cured film formed using the resin composition, a stack including the cured film, an imaging device including the stack, a semiconductor device including the stack, a method for producing the stack, and a method for producing an element including a bonding electrode for use in production of the stack.

BACKGROUND ART

With higher performance of semiconductor devices, 3D stacking of multiple semiconductor chips has been developed. The production of such a stack of multiple semiconductor chips first includes the formation of a bonding surface, which includes copper-made bonding electrodes surrounded by an insulating film, by the damascene process on each of the electrode surfaces of two elements provided with the electrodes. The two elements are stacked on top of each other such that the bonding electrodes of the bonding surfaces face each other, and then heat-treated to produce a stack (Patent Literature 1).

CITATION LIST

- Patent Literature

Patent Literature 1: JP 2006-191081 A

SUMMARY OF INVENTION

- Technical problem

In the production of the stack, bonding of the electrodes involves high-temperature treatment at 400°C for four hours. The insulating layers used to form the bonding surfaces thus require high heat resistance. Conventional stacks therefore use insulating inorganic materials such as SiN and $SiO_2$ as the insulating layers. However, insulating layers made of inorganic materials tend to cause warping of the elements. A warped element may cause misalignment of the electrode connection positions or cracking of electrodes in the stack to be obtained. This may reduce the connection reliability of the stack. As the recent semiconductor devices have higher performance, elements have become larger and thinner and become more susceptible to warping.

With the recent increase in functionality of elements, irregularities with sizes of several to several tens of micrometers may be formed on the element surfaces on which insulating layers are to be formed. When elements having irregularities are directly bonded, from the standpoint of the connection reliability between electrodes, wafer surfaces with the elements need to be covered with insulating layers to planarize the bonding surfaces before the elements are connected to each other. There is a demand for materials that can form insulating layers having excellent heat resistance, excellent flexibility, and excellent element-planarization properties.

The present invention aims to provide a resin composition that excels in heat resistance and flexibility and can planarize bonding surfaces of elements even when the elements have irregularities on the surfaces, thus imparting high electrical connection reliability between the elements, as well as a cured film formed using the resin composition, a stack including the cured film, an imaging device including the stack, a semiconductor device including the stack, a method for producing the stack, and a method for producing an element including a bonding electrode for use in production of the stack.

- Solution to problem

The present invention encompasses the following disclosures 1 to 23. The present invention is described in detail below.

[Disclosure 1]

A resin composition containing: an organosilicon compound; and a modifier,

the modifier having a thermal weight loss of 10% or less between before and after being maintained at 400°C for three

hours when the modifier alone is heated from room temperature to 300°C in the air at a temperature increase rate of 10°C/min, maintained for one hour, then heated to 400°C at a temperature increase rate of 10°C/min, and maintained at 400°C for three hours,

a sample, prepared by adding the organosilicon compound and 1 part by weight of the modifier relative to 100 parts by weight of the organosilicon compound to ethyl benzoate such that the sample has a viscosity at 25°C of 45 cP, having a contact angle of 9° or greater and 20° or less on a silicon wafer when the sample is dropped onto the silicon wafer.

[Disclosure 2]

The resin composition according to the disclosure 1, wherein the resin composition further contains a solvent, and the resin composition forms a cured resin film having a surface free energy of 27 $mJ/m^2$ or greater, the cured resin film being obtained by spin coating the resin composition as a solution with a viscosity of 1,200 cP in the solvent on a silicon wafer at 1,500 rpm for 10 seconds, removing the solvent by drying, and curing the resulting product at 300°C for one hour into a cured resin film with a thickness of 10 μm or greater.

[Disclosure 3]

The resin composition according to the disclosure 1 or 2, containing a metal catalyst, a crosslinking agent, and a heat resistant additive.

[Disclosure 4]

The resin composition according to any one of the disclosures 1 to 3, wherein the organosilicon compound has a structure represented by the following formula (1):

[Chem. 1]

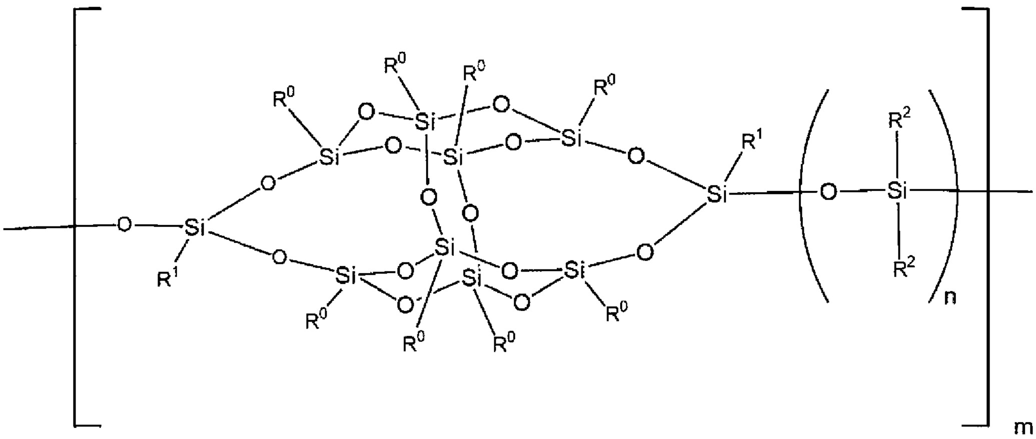

(1)

wherein $R^0$s, $R^1$s, and $R^2$s each independently represent a linear, branched, or cyclic aliphatic group, an aromatic group, or hydrogen; the aliphatic group and the aromatic group each optionally have a substituent; and m and n each represent an integer of 1 or greater.

[Disclosure 5]

The resin composition according to any one of the disclosures 1 to 4, wherein the modifier has a polyether-modified group.

[Disclosure 6]

The resin composition according to any one of the disclosures 1 to 5, wherein the resin composition contains the modifier in an amount of 0.01 parts by weight or more and 10 parts by weight or less relative to 100 parts by weight of the organosilicon compound.

[Disclosure 7]

The resin composition according to any one of the disclosures 1 to 6, wherein the modifier has a weight average molecular weight of 4,000 or greater and 30,000 or less.

[Disclosure 8]

The resin composition according to the disclosure 2, wherein a cured product obtained after removing the solvent by drying and then curing the resulting product at 300°C for one hour has a 1% weight loss temperature of 460°C or higher.

[Disclosure 9]

The resin composition according to any one of the disclosures 1 to 8, wherein the resin composition is used to form an insulating layer on a surface with irregularities of an element having a surface with irregularities.

[Disclosure 10]

A resin composition containing: an organosilicon compound; and a modifier,

the organosilicon compound having a structure represented by the following formula (1):

[Chem. 2]

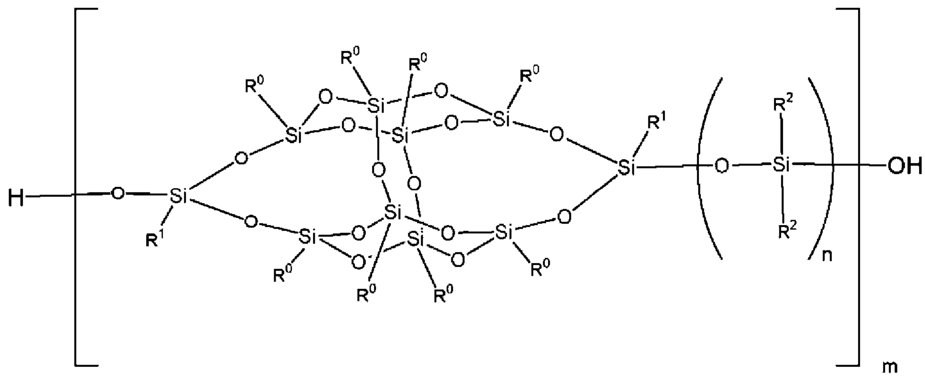

(1)

wherein $R^0$s, $R^1$s, and $R^2$s each independently represent a linear, branched, or cyclic aliphatic group, an aromatic group, or hydrogen; the aliphatic group and the aromatic group each optionally have a substituent; and m and n each represent an integer of 1 or greater,
the modifier having a polyether-modified group.

[Disclosure 11]

A cured film formed using the resin composition according to any one of the disclosures 1 to 10.

[Disclosure 12]

A stack including: a first element including an electrode; a second element including an electrode; and the cured film according to the disclosure 11 between the first element and the second element,
the electrode of the first element and the electrode of the second element being electrically connected to each other via a through-hole extending through the cured film.

[Disclosure 13]

The stack according to the disclosure 12, including an inorganic layer between the first element and the second element.

[Disclosure 14]

The stack according to the disclosure 12 or 13, including a barrier metal layer on a surface of the through-hole.

[Disclosure 15]

An imaging device including the stack according to any one of the disclosures 12 to 14.

[Disclosure 16]

A semiconductor device including the stack according to any one of the disclosures 12 to 14.

[Disclosure 17]

A method for producing a stack, including the steps of:

forming cured films by forming a film of the resin composition according to any one of the disclosures 1 to 10 on a surface of a first element including an electrode, the surface being a surface on which the electrode is formed, and a film of the resin composition on a surface of a second element including an electrode, the surface being a surface on which the electrode is formed, and curing the films;
forming a through-hole in each of the cured films;
filling each of the through-holes with a conductive material;
forming bonding electrodes by polishing the surface of the first element on the side where the through-hole is filled with the conductive material and the surface of the second element on the side where the through-hole is filled with the conductive material; and
bonding the first element on which the bonding electrode is formed and the second element on which the bonding electrode is formed such that the bonding electrodes are bonded to each other.

[Disclosure 18]

A method for producing an element including a bonding electrode, including the steps of:

forming a cured film by forming a film of the resin composition according to any one of the disclosures 1 to 10 on a surface of an element including an electrode, the surface being a surface on which the electrode is formed, and curing the film;
forming a through-hole in the cured film;
filling the through-hole with a conductive material; and
forming a bonding electrode by polishing the surface of the element including the electrode, the surface being on the side where the through-hole is filled with the conductive material.

[Disclosure 19]

A stack including:

a supporting substrate;
a third element; and
the cured film according to the disclosure 11 between the supporting substrate and the third element,
the third element having a first surface and a second surface, the first surface including a plurality of chips,
the cured film being stacked on the first surface side.

[Disclosure 20]

The stack according to the disclosure 19, including an inorganic layer between the supporting substrate and the cured film.

[Disclosure 21]

The stack according to the disclosure 19 or 20,

wherein the stack further includes a fourth element on the second surface of the third element, and the third element and the fourth element are electrically connected to each other.

[Disclosure 22]

An imaging device including the stack according to any one of the disclosures 19 to 21.

[Disclosure 23]

A semiconductor device including the stack according to any one of the disclosures 19 to 21.

The resin composition of the present invention contains an organosilicon compound.

When an insulating layer in a stack of elements is formed of a cured product of the resin composition of the present invention, which is organic matter, the insulating layer can have high flexibility, reducing warping of the elements and increasing the electrical connection reliability. Moreover, the use of an organosilicon compound in the resin composition enables production of an insulating layer that excels in heat resistance and element-planarization properties.

The organosilicon compound is preferably silsesquioxane.

Silsesquioxane has flexibility equivalent to that of organic compounds and also has high heat resistance. Thus, use of a cured film mainly containing silsesquioxane as an insulating layer in a stack can suppress warping and cracking of a substrate to enhance the electrical connection reliability. The silsesquioxane may be any heat curable silsesquioxane. To further suppress warping and cracking of a substrate, the silsesquioxane preferably has a structure represented by the following structural formula (A) or (B) in one molecule.

[Chem. 3]

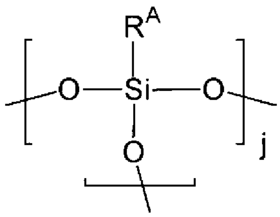

(A)

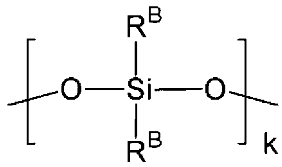

(B)

In the structural formula (A) or (B), $R^A$ and $R^B$ each independently represent an aliphatic group, an aromatic group, or hydrogen, j and k each represent a repeating unit and the number thereof is an integer of 1 or greater.

The organosilicon compound more preferably has a structure represented by the following formula (1). With the organosilicon compound having a structure represented by the following formula (1), the resin composition obtains higher heat resistance. Also, the resin composition, when used in an insulating layer in a stack, can further suppress misalignment or cracking of electrodes and thus can further enhance electrical connection reliability. The organosilicon compound represented by the following formula (1) can be bonded to a modifier described below and therefore can disperse the modifier in the entire resin composition. Thus, the use of the resin composition in an insulating layer in a stack can better enhance element planarization properties. Further, such a resin composition can more easily satisfy the contact angle on a silicon wafer described later.

[Chem. 4]

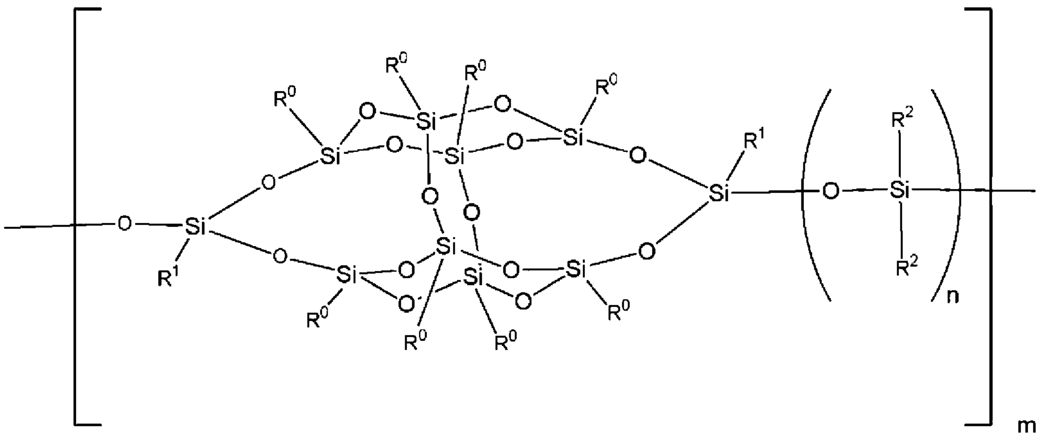

(1)

In the formula, $R^0$s, $R^1$s, and $R^2$s each independently represent a linear, branched, or cyclic aliphatic group, an aromatic group, or hydrogen; the aliphatic group and the aromatic group each optionally have a substituent; and m and n each represent an integer of 1 or greater.

In the formula (1), $R^0$s each independently represent a linear, branched, or cyclic aliphatic group, an aromatic group, or hydrogen; the aliphatic group and the aromatic group each optionally have a substituent; and $R^0$s are each preferably a phenyl group, a C1-C20 alkyl group, or an arylalkyl group, more preferably a phenyl group. When $R^0$s are each a phenyl group, a C1-C20 alkyl group, or an arylalkyl group, the organosilicon compound can have higher heat resistance.

In the formula (1), $R^1$s and $R^2$s each independently represent a linear, branched, or cyclic aliphatic group, an aromatic group, or hydrogen; the aliphatic group and the aromatic group each optionally have a substituent; and $R^1$s and $R^2$s are each preferably a phenyl group, a C1-C20 alkyl group, or an arylalkyl group, more preferably a phenyl group or a methyl group. When $R^1$s and $R^2$s are each a phenyl group, a C1-C20 alkyl group, or an arylalkyl group, the organosilicon compound can have higher heat resistance.

In the formula (1), m and n are each an integer of 1 or greater and represent the number of repeating units; m is preferably 30 or greater, more preferably 50 or greater and is preferably 100 or less; and n is preferably 1 or greater, more preferably 3 or greater, still more preferably 4 or greater and is preferably 8 or less, more preferably 6 or less.

The organosilicon compound preferably has a reactive site.

When a reactive site-containing organosilicon compound is used as a curable resin of the resin composition and the resin composition is used in an insulating layer in a stack, warping of elements and misalignment or cracking of electrodes can be further suppressed. Moreover, since the organosilicon compound excels in heat resistance, using the reactive site-containing organosilicon compound can further reduce decomposition of a cured film during high-temperature treatment performed in the production of an electronic component. Examples of the reactive site include a hydroxy group and an alkoxy group. Examples of the reactive site-containing organosilicon compound include organosilicon compounds represented by the formula (1).

The amount of the organosilicon compound in 100 parts by weight of the amount of solids (amount of components other than the solvent) in the resin composition is preferably 80 parts by weight or more, more preferably 90 parts by weight or more, still more preferably 95 parts by weight or more. The amount of the organosilicon compound in 100 parts by weight of the amount of solids in the resin composition is preferably less than 100 parts by weight, more preferably 98 parts by weight or less.

The organosilicon compound may have any weight average molecular weight and preferably has a weight average molecular weight of 5,000 or greater and 150,000 or less. When the molecular weight of the organosilicon compound is within the range, the film-forming properties in application can be increased to further enhance the planarization properties. Additionally, the use of the resin composition in an insulating layer in a stack can further suppress warping of elements and misalignment or cracking of electrodes. The molecular weight of the organosilicon compound is more preferably 10,000 or greater, still more preferably 30,000 or greater and is more preferably 100,000 or less, still more preferably 70,000 or less.

The weight average molecular weight of the organosilicon compound is measured by gel permeation chromatography (GPC) as a polystyrene equivalent molecular weight. The weight average molecular weight can be calculated with polystyrene standards using THF as an elution solvent and HR-MB-M 6.0 × 150 mm (available from Waters Corporation) or its equivalent as a column.

The organosilicon compound is preferably dissolved in the resin composition and is preferably dispersed not in a specific shape, such as particles, from the standpoint of further increasing the film-forming properties upon application to further increase the planarization properties as well as further suppressing warping of elements and misalignment or cracking of electrodes when used in an insulating layer in a stack.

The resin composition of the present invention contains a modifier.

When the resin composition has a certain thermal weight loss described below and is used in combination with the organosilicon compound, and also contains a modifier which is selected to satisfy a contact angle on a silicon wafer described below, the resin composition can planarize a bonding surface even when it is used on elements having surfaces with irregularities and thus can impart high electrical connection reliability between the elements. Here, planarization of a bonding surface requires stable film formation even at high temperature. Therefore, a combination of the modifier with an organosilicon compound merely having flexibility may not prevent occurrence of film cracking and may lead to poor planarization of the bonding surface.

The modifier has a thermal weight loss of 10% or less between before and after being maintained at 400°C for three hours when the modifier alone is heated from room temperature to 300°C in the air at a temperature increase rate of 10°C/min, maintained for one hour, then heated to 400°C at a temperature increase rate of 10°C/min, and maintained at 400°C for three hours,

When the thermal weight loss of the modifier under the above conditions is within the range, it is possible to suppress thermal decomposition of the modifier, even after treatment at high temperature, and suppress film cracking of an insulating layer due to thermal decomposition. Thus, the resin composition used on an element can sufficiently fill irregularities of the surface of the element. From the standpoint of further increasing heat resistance of a cured product of the resin composition, the thermal weight loss is preferably 8% or less, more preferably 5% or less.

The thermal weight loss can be controlled by the molecular weight and the types of functional groups. The thermal weight loss can be measured using a simultaneous differential thermogravimetric analyzer (TG-DTA; STA7200, available from Hitachi High-Technologies Corporation or its equivalent), specifically by the following method.

Using a simultaneous differential thermogravimetric analyzer (TG-DTA; STA7200, available from Hitachi High-Technologies Corporation or its equivalent), the modifier is heated from 25°C to 300°C in the air at a temperature increase rate of 10°C/min and maintained for one hour. After the modifier is maintained for one hour, it is heated to 400°C at a temperature increase rate of 10°C/min and then maintained at 400°C for three hours. The thermal weight loss is calculated from the weight when the temperature first reached 400°C and the weight three hours after being maintained at 400°C among the weights at temperatures in the process.

The modifier may be any modifier that has the above-described thermal weight loss and a contact angle on a silicon wafer described below. Examples of compounds which are likely to satisfy such properties include polyether compounds, aralkyl compounds, polyester compounds, and silicone compounds. Of these, the modifier preferably has a polyether-modified group and is more preferably a silicone compound having a polyether-modified group so that it is likely to satisfy the thermal weight loss and the contact angle on a silicon wafer described below and the resin composition can planarize a bonding surface even when it is used on an element having a surface with irregularities.

The amount of the modifier is not limited. To further planarize the bonding surface of an element, the amount of the modifier relative to 100 parts by weight of the organosilicon compound is preferably 0.01 parts by weight or more, more preferably 0.1 parts by weight or more, still more preferably 0.3 parts by weight or more and is preferably 10 parts by weight or less, more preferably 1 part by weight or less, still more preferably 0.7 parts by weight or less.

The modifier preferably has a weight average molecular weight of 4,000 or greater and 30,000 or less. When the weight average molecular weight of the modifier is within the above range, the bonding surface of an element can be further planarized. The weight average molecular weight of the modifier is more preferably 15,000 or greater, still more preferably 20,000 or greater and is more preferably 30,000 or less, still more preferably 25,000 or less. The weight average molecular weight of the modifier can be measured by the same method as the method for measuring the weight average molecular weight of the organosilicon compound.

The resin composition of the present invention preferably contains a solvent.

When the resin composition contains a solvent, the viscosity of the organosilicon compound can be controlled to be sufficient for application to an element, while the resin composition, when used on an element, can fill irregularities on the surface of the element to further planarize the surface. The solvent may be composed of a single component or may be a mixture of a plurality of components.

The solvent is not limited. Examples of the solvent include ketone solvents such as cyclopentanone, ester solvents such as ethyl benzoate, and other solvents such as lactone solvents, lactam solvents, and glycol ether solvents. To further planarize the bonding surface of an element, cyclopentanone is preferred among these.

The solvent preferably has a boiling point of 150°C or higher and 250°C or lower.

When the boiling point of the solvent is within the range, the planarization properties can be further enhanced. When the boiling point of the solvent satisfies the above-described lower limit, it is possible to prevent foreign object-derived defects caused by string-like vaporization of the solvent and subsequent adhesion to the coating during spin

coating. The boiling point of the solvent is more preferably 170°C or higher, still more preferably 180°C or higher and is more preferably 230°C or lower, still more preferably 220°C or lower. Examples of solvents having a boiling point within the range include aromatic organic solvents, lactam organic solvents, and lactone organic solvents. A lactam organic solvent is an organic solvent of a heterocyclic compound having -C(=O)NRin the ring. A lactone compound is an organic solvent of a heterocyclic compound having -C(=O)- in the ring. Here, R represents a hydrocarbon. Examples of specific compounds include cyclopentanone (boiling point: 131°C), propylene glycol monomethyl ether acetate (boiling point: 146°C), anisole (boiling point: 154°C), ethyl benzoate (boiling point :211°C to 213°C), N-methyl-2-pyrrolidone (boiling point: 202°C), 2-piperidone (boiling point: 256°C), 2-pyrrolidone (boiling point: 245°C), γ-butyrolactone

(boiling point: 204°C), and γ-valerolactone (boiling point: 207°C) .

The solvent is preferably contained in an amount of 50% by weight or less in the resin composition.

When the amount of the solvent in the resin composition is within the range, shrinking due to vaporization of the solvent in curing is small, so that the resulting cured film is less likely to have irregularities, providing a planar bonding surface. As a result, the element bonding reliability can be enhanced, and the electrical connection reliability can also be enhanced.

The amount of the solvent is preferably 45% by weight or less, more preferably 40% by weight or less, still more preferably 35% by weight or less. The lower limit of the amount of the solvent is not limited. From the standpoint of further enhancing the planarization properties, the lower limit is preferably 30% by weight or more.

The amount of the solvent is preferably 50 parts by weight or more and 100 parts by weight or less relative to 100 parts by weight of the organosilicon compound.

When the amount of the solvent relative to the amount of the organosilicon compound is within the range, the element surface-planarizing properties can be further enhanced. The amount of the solvent relative to the organosilicon compound is more preferably 55 parts by weight or more, still more preferably 60 parts by weight or more and is more preferably 80 parts by weight or less, still more preferably 70 parts by weight or less.

The resin composition of the present invention preferably contains a metal catalyst that promotes curing reaction.

When the resin composition contains a metal catalyst, the resin composition can be more completely cured, which can further reduce the decomposition of the cured film due to high-temperature treatment.

Examples of the metal catalyst include: organotin compounds such as dibutyltin dilaurate and tin(II) acetate; metal carboxylates such as zinc naphthenate; zirconia compounds such as zirconium tetraacetylacetonate; and titanium compounds. Preferred among these are zirconium tetraacetylacetonate and dibutyltin dilaurate because they can further promote curing of the resin composition.

The metal catalyst remains after the resin composition is cured. In other words, the cured film obtained by curing the resin composition of the present invention preferably contains a metal catalyst that promotes curing reaction.

The amount of the catalyst is not limited and is preferably 0.01 parts by weight or more and 10 parts by weight or less relative to 100 parts by weight of the organosilicon compound in the resin composition. When the amount of the catalyst is within the range, curing of the resin composition can be further promoted. The amount of the catalyst is more preferably 0.1 parts by weight or more, still more preferably 0.2 part by weight or more and is more preferably 7 parts by weight or less, still more preferably 5 parts by weight or less.

The resin composition of the present invention preferably contains a crosslinking agent.

Crosslinking between the polymers of the reactive site-containing organosilicon compound by a crosslinking agent capable of reacting with a reactive site of the organosilicon compound increases the crosslinking density of the resulting cured product, thus further reducing decomposition at high temperature. Therefore, the use of such a resin composition in an insulating layer in a stack can further prevent generation of voids due to decomposed gas generated during high-temperature treatment as well as resulting misalignment of electrodes during bonding and reduction in electrical connection reliability. Examples of the crosslinking agent in the case where the reactive site is a silanol group include alkoxysilane compounds such as dimethoxysilane compounds, trimethoxysilane compounds, diethoxysilane compounds, and triethoxysilane compounds and silicate oligomers obtained by condensation of a tetramethoxysilane compound and a tetraethoxysilane compound. From the standpoint of improving the crosslinking density and heat resistance, silicate oligomers are preferred among these. Examples of alkoxysilane compounds include dimethoxydimethylsilane, trimethoxymethylsilane, tetraethoxysilane, tetrapropoxysilane, and tetrabutoxysilane. Examples of silicate oligomers include Silicate MS51, Silicate MS56, Silicate MS57, and Silicate MS56S (all available from Mitsubishi Chemical Corporation) and Ethyl Silicate 40, Ethyl Silicate 48, and EMS 485 (all available from Colcoat Co., Ltd.).

The amount of the crosslinking agent is not limited and is preferably 1 part by weight or more and 50 parts by weight or less relative to 100 parts by weight of the organosilicon compound in the resin composition. When the amount of the crosslinking agent is within the range, the resulting cured film can have a crosslinking density within a suitable range. The amount of the crosslinking agent is more preferably 3 parts by weight or more, still more preferably 3.2 parts by weight or more and is more preferably 30 parts by weight or less, still more preferably 20 parts by weight or less.

The resin composition of the present invention preferably contains a heat resistant additive.

The use of a heat resistant additive in the resin composition allows a cured product of the resin composition to

have excellent heat resistance. Examples of the heat resistant additive include polyimide resin, epoxy resin, silicone resin, benzoxazine resin, cyanate resin, and phenolic resin. To further enhance heat resistance, polyimide resin is preferred among these.

Although the weight average molecular weight of the heat resistant additive is not limited, the heat resistant additive preferably has a weight average molecular weight of 5,000 or greater and 150,000 or less. When the weight average molecular weight of the heat resistant additive is within the range, the viscosity and solid concentration of the resin composition can easily be adjusted to the ranges of the present invention. The molecular weight of the heat resistant additive is more preferably 10,000 or greater, still more preferably 30,000 or greater and is more preferably 100,000 or less, still more preferably 70,000 or less.

The amount of the heat resistant additive is not limited. From the standpoint of further improving the heat resistance, the amount is preferably 0.1 parts by weight or more, more preferably 0.5 parts by weight or more and is preferably 10 parts by weight or less, more preferably 5 parts by weight or less, relative to 100 parts by weight of the organosilicon compound.

When the heat resistant additive is a polyimide, the polyimide preferably has a siloxane bond.

When the polyimide has a siloxane bond, the compatibility of the polyimide with the organosilicon compound contained in the resin composition is enhanced, so that irregularities (surface roughening) due to precipitation of the polyimide in application can be further reduced.

When the polyimide has a siloxane bond, the polyimide preferably has a ratio of carbon atoms to silicon atoms, C/Si, of 17 or less in the main chain structure.

When the ratio of carbon atoms to silicon atoms in the main chain of the polyimide is within the range, the compatibility of the polyimide with the organosilicon compound contained in the resin composition is further enhanced, so that surface roughening in application can be further reduced. The C/Si is more preferably 16.5 or less, still more preferably 16 or less. The lower limit of the C/Si is not limited, but is preferably 4 or greater, from the standpoint of practical use and further enhancing the heat resistance at 400°C. Here, the ratio of carbon atoms to silicon atoms, C/Si, in the main chain structure of the polyimide is the ratio of C to Si in the repeating units and excludes C and Si at both terminals. The C/Si can be determined by obtaining the structure of the polyimide by $^{1}$H-NMR, $^{13}$C-NMR, and $^{29}$Si-NMR and measuring the number of C atoms and Si atoms from the repeating units of the main chain.

The polyimide preferably has a plurality of aromatic rings.

When the polyimide has a plurality of aromatic rings, even a thick cured film of the resin composition is less likely to crack in high-temperature treatment under various conditions.

The polyimide preferably has an oxazine ring or imide ring structure at at least one terminal, more preferably both terminals.

The polyimide having an oxazine ring or imide ring structure at a terminal can further reduce surface roughening when a thick film is formed. The oxazine ring structure and the imide ring structure may have a substituent.

The polyimide still more preferably has a structure of any of the formulas (2) to (7) at at least one terminal, particularly preferably both terminals. Here, "*" in the formulas represents a linking site to a portion other than the terminal of the polyimide.

[Chem. 5]

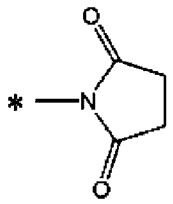 (2)

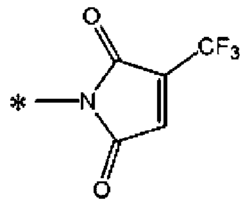 (3)

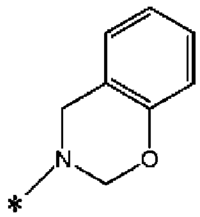 (4)

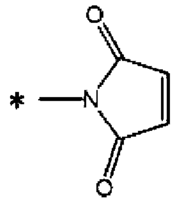 (5)

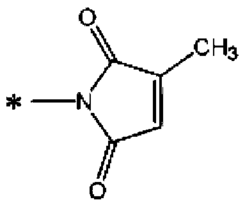 (6)

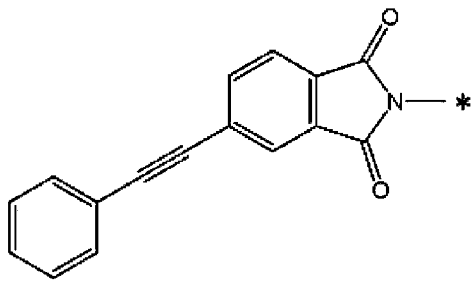 (7)

The polyimide preferably has a weight average molecular weight of 1,000 or greater and 50,000 or less.

When the weight average molecular weight of the polyimide is within the range, the compatibility of the polyimide with the organosilicon compound can be improved, leading to higher handleability. The weight average molecular weight is more preferably 2,000 or greater, still more preferably 3,000 or greater and is more preferably 35,000 or less, still more preferably 30,000 or less.

The weight average molecular weight of the polyimide is measured by gel permeation chromatography (GPC) as a polystyrene equivalent molecular weight. The weight average molecular weight can be calculated with polystyrene standards using THF as an elution solvent and HR-MB-M 6.0 $\times$ 150 mm (available from Waters Corporation) or its equivalent as a column.

The amount of the polyimide is preferably 0.5 parts by weight or more and 50 parts by weight or less relative to 100 parts by weight of the organosilicon compound.

When the amount of the polyimide is within the range, even a thick cured film of the resin composition is less likely to crack in high-temperature treatment. The amount of the polyimide is preferably 0.7 parts by weight or more, more preferably 0.75 parts by weight or more, still more preferably 1 part by weight or more and is preferably 20 parts by weight or less, more preferably 10 parts by weight or less, still more preferably 5 parts by weight or less, relative to 100 parts by weight of the organosilicon compound.

The resin composition of the present invention may contain other additives such as viscosity-controlling agents, fillers, or adhesion promoters as needed. Note that the resin composition preferably does not contain fluorescent agents from the standpoint of reducing thermal decomposition at high temperature to thus increase heat resistance.

The resin composition of the present invention has the following feature: a sample, prepared by adding the organosilicon compound and 1 part by weight of the modifier relative to 100 parts by weight of the organosilicon compound to ethyl benzoate such that the sample has a viscosity at 25°C of 45 cP has a contact angle of 9° or greater and 20° or less on a silicon wafer when the sample is dropped onto the silicon wafer.

When a solution with a specific viscosity of the organosilicon compound and a specific amount of the modifier in ethyl benzoate is controlled to have a contact angle within the range on a silicon wafer, the resin composition can reach the bottom faces of dented parts to thus planarize the bonding surface.

From the standpoint of further planarizing the bonding surface of an element, the contact angle is preferably 12° or greater, more preferably 14° or greater and is preferably 18° or less, more preferably 15° or less. The contact angle can be controlled by a combination of the type of the organosilicon compound and the type of the modifier. Specifically, for example, the contact angle can be easily controlled to be within the range when a compound having a structure

represented by the formula (1) and a compound having a polyether-modified group are used as the organosilicon compound and the modifier, respectively.

Here, the viscosity at 25°C can be determined by measuring the kinetic viscosity at a shear rate of 10.0 rpm at 25°C using an E-type viscometer (TVE100H, available from Toki Sangyo Co., Ltd., or its equivalent). The contact angle can be measured by a method in conformity with JIS R 3257, specifically by the following method.

The organosilicon compound and 1 part by weight of the modifier relative to 100 parts by weight of the organosilicon compound are added to ethyl benzoate to prepare a sample having a viscosity of 45 cP at 25°C. The sample is dropped onto a silicon wafer using a contact angle measuring device (full automatic contact angle meter DMo-702, available from Kyowa Interface Science Co., Ltd., or its equivalent) to measure the contact angle of the sample on the silicon wafer.

Preferably, the resin composition of the present invention further contains a solvent, and preferably the resin composition as a solution with a viscosity of 1,200 cP in the solvent forms a cured resin film having a surface energy of 27 $mJ/m^2$ or greater, when the cured resin film is obtained by spin coating the solution on a silicon wafer at 1,500 rpm for 10 seconds, removing the solvent by drying, and curing the resulting product at 300°C for one hour into a cured resin film with a thickness of 10 $\mu$m or greater.

When the surface free energy of the cured resin film is within the above range, the wettability on the Si wafer can be reduced and also the flowing of the resin composition can be suppressed. Thus, the resin composition can planarize a bonding surface even when it is used on an element having a surface with irregularities. From the standpoint of further planarizing the bonding surface of an element, the surface free energy of the cured resin film is more preferably 30 $mJ/m^2$ or greater, still more preferably 33 $mJ/m^2$ or greater and is more preferably 38 $mJ/m^2$ or less, still more preferably 35 $mJ/m^2$ or less.

The surface free energy of the cured resin film can be controlled by the type and amount of the organosilicon compound, the type and amount of the modifier, the type and amount of the catalyst, the type and amount of the crosslinking agent, the type and amount of the heat resistant additive, the type of the solvent, or the like. The surface energy of the cured resin film can be measured using a contact angle measuring device (full automatic contact angle meter DMo-702, available from Kyowa Interface Science Co., Ltd., or its equivalent), specifically by the following method. The solvent may have the above-described viscosity and may be any solvent that completely evaporates upon formation of a cured resin film. Examples include the solvents described above.

The resin composition is mixed with a solvent to prepare a solution having a viscosity at 25°C of 1,200 cP. The solution is dropped onto a central portion of an 8-inch silicon wafer at room temperature. The dropped resin composition is applied to the silicon wafer using a spin coater (ACT-400II, available from ACTIVE or its equivalent) at 1,500 rpm for 10 seconds. The solution-applied wafer is heated at 125°C for 10 minutes to remove the solvent by drying. Subsequently, the wafer is heated at 300°C for one hour to obtain a cured resin film with a thickness of 10 $\mu$m or greater. Water and diiodomethane are dropped onto the obtained cured resin film using a contact angle measuring device (full automatic contact angle meter DMo-702, available from Kyowa Interface Science Co., Ltd. or its equivalent). The contact angles of the liquids on the cured resin film are measured to determine a dispersion energy, $\gamma^d$, and an interaction energy, $\gamma^h$. The surface free energy, $\gamma$, is calculated from the sum of the $\gamma^d$ and the $\gamma^h$.

Preferably, the resin composition of the present invention can be formed into a cured product having a 1% weight loss temperature of 440°C or higher when it is cured at 300°C for one hour after removing the solvent by drying.

When the weight loss of the cured product is within the range, elements can be more reliably connected with each other, and also occurrence of bubbles and cracks at the interface caused by decomposition of the cured product during electrode bonding and delamination at the interface can be further suppressed. The weight loss temperature is more preferably 450°C or higher, still more preferably 460°C or higher. The upper limit of the weight loss temperature is not limited. The upper limit is preferably as high as possible but may be at most about 480°C in view of the production technology.

The weight loss temperature can be controlled by the formulation of the resin composition, the type of a resin material of the resin composition, the conditions for curing the resin composition, or the like.

Specifically, the weight loss temperature can be increased by, for example, using a resin material with high heat resistance or an inorganic component in the resin composition or increasing the amount of the crosslinking agent.

The weight loss temperature can also be increased by selecting a resin with high heat resistance (for example, a resin having a high molecular weight, a resin having a main chain or substituent with high heat resistance) as the resin material.

The weight loss temperature of a cured product of the resin composition can specifically be measured by the following method.

The resin composition is applied in sheet form using an applicator or other instruments and then dried by heating at 125°C for 10 minutes. Subsequently, the dried resin composition is heated at 300°C for one hour to obtain a film of a cured product (cured film) of the resin composition with a thickness of 35 $\mu$m. An amount of 3 to 10 mg of the film is weighed out and heated using a simultaneous differential thermogravimetric analyzer (TG-DTA; STA7200, available from Hitachi

High-Technologies Corporation or its equivalent) under 50 mL/min nitrogen flow at a temperature increase rate of 10°C/min. The temperature at which the weight loss reaches 1% is measured.

The resin composition of the present invention may be produced by any method. For example, the resin composition can be produced by mixing the organosilicon compound, the modifier, and optionally additives such as the catalyst and the crosslinking agent.

The resin composition of the present invention that contains the organosilicon compound and the modifier satisfying the weight loss and satisfies the contact angle on a silicon wafer can obtain excellent heat resistance and excellent flexibility, can planarize bonding surfaces of elements even when the elements have irregularities on the surfaces, and thus can impart high electrical connection reliability between the elements. In the case where the organosilicon compound is an organosilicon compound represented by the formula (1), the resin composition in which the modifier has a polyether-modified group can exhibit the effects of the present invention.

The present invention also encompasses such a resin composition that contains an organosilicon compound having a structure represented by the following formula (1) and a modifier having a polyether-modified group. Here, the details of the organosilicon compound, the modifier, other additives, and various physical properties are as described above.

[Chem. 6]

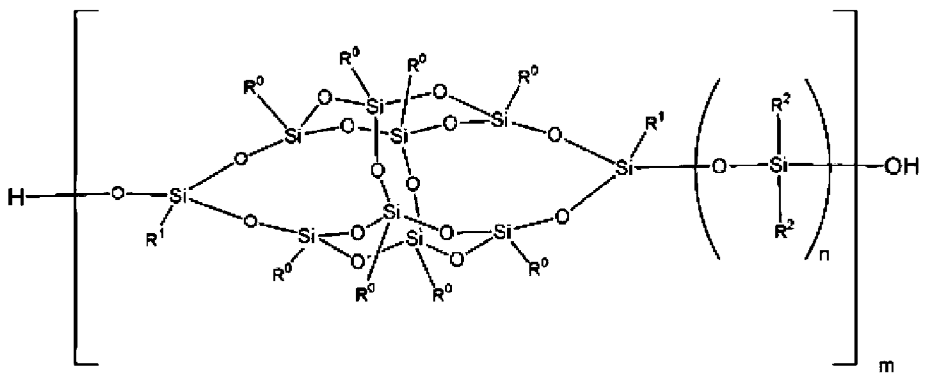

(1)

In the formula, $R^0$s, $R^1$s, and $R^2$s each independently represent a linear, branched, or cyclic aliphatic group, an aromatic group, or hydrogen; the aliphatic group and the aromatic group each optionally have a substituent; and m and n each represent an integer of 1 or greater.

The use of the resin composition of the present invention is not limited. Since the resin composition has excellent ability of filling and planarizing irregularities and can form a cured film with heat resistance and flexibility, the resin composition is suitably for use in forming an insulating layer on a surface with irregularities of an element having a surface with irregularities or an insulating layer in producing a stack of two elements each having an electrode by electrically connecting the electrodes.

The present invention also encompasses such a resin composition of the present invention for use in forming an insulating layer on a surface with irregularities of an element having a surface with irregularities and a cured film formed using the resin composition of the present invention.

Examples of the element include a sensor circuit element provided with a pixel section (pixel area) and a circuit element equipped with a peripheral circuit such as a logic circuit that performs various signal processing for the operation of a solid-state imaging device.

The cured film of the present invention preferably has a 1% weight loss temperature of 440°C or higher.

When the weight loss of the cured film after it is heated in nitrogen is within the range, elements can be more reliably connected with each other, and also occurrence of bubbles and cracks at the interface caused by decomposition of the cured product during electrode bonding and delamination at the interface can be further suppressed. The weight loss temperature is more preferably 450°C or higher, still more preferably 460°C or higher.

The upper limit of the weight loss temperature is not limited. The upper limit is preferably as high as possible but may be at most about 480°C in view of the production technology.

The weight loss temperature can be controlled by the formulation of the resin composition, the type of a resin material of the resin composition, the conditions for curing the resin composition, or the like.

Specifically, the weight loss temperature can be increased by, for example, using a resin material with high heat resistance or an inorganic component in the resin composition or increasing the amount of the crosslinking agent.

The weight loss temperature can also be increased by selecting a resin with high heat resistance (for example, a resin having a high molecular weight, a resin having a main chain or substituent with high heat resistance) as the resin material constituting the cured film or by curing the resin composition, which is a raw material of the cured film, at a high temperature or for a long time for sufficient progressing of the curing.

The weight loss temperature of the cured film can specifically be measured by the following method.

An amount of 3 to 10 mg of the cured film is weighed out and heated using a simultaneous differential thermogravimetric analyzer (TG-DTA; STA7200, available from Hitachi High-Technologies Corporation or its equivalent) under 50 mL/min nitrogen flow at a temperature increase rate of 10°C/min. The temperature at which the weight loss reaches 1% is measured.

The present invention also encompasses a stack including a first element including an electrode, a second element including an electrode, and the cured film of the present invention between the first element and the second element, the electrode of the first element and the electrode of the second element being electrically connected to each other via a through-hole extending through the cured film (hereinafter the stack is also referred to as a stack A). The stack of the present invention is described below.

The stack A of the present invention includes a first element including an electrode, a second element including an electrode, and the cured film of the present invention between the first element and the second element. The electrode of the first element and the electrode of the second element are electrically connected to each other via a through-hole extending through the cured film.

The cured film provided between the electrode of the first element (hereinafter also referred to as a first electrode) and the electrode of the second element (hereinafter also referred to as a second electrode) serves as an insulating layer to reduce short-circuit current. Conventional insulating layers contain hard inorganic materials such as SiN and $SiO_2$, and thus cannot eliminate warping by stress relaxation when warping occurs in the formation of an insulating layer or in the formation of a stack. As a result, warping of elements and misalignment or cracking of electrodes due to the warping are likely to occur. In the present invention, the cured film including a resin that is more flexible than an inorganic material is used as an insulating layer, so that high electrical connection reliability can be achieved. In particular, the resin composition of the present invention, from which the cured film is formed, can fill irregularities and planarize a bonding surface of an element even when the element has irregularities, resulting in a stack having high electrical connection reliability. Conventional insulating layers are formed by vapor deposition and therefore take time to produce. However, the cured film of the stack of the present invention can be formed by, for example, applying and curing the resin composition, thus increasing production efficiency.

The phrase "electrically connected" as used herein means a state in which the first electrode and the second electrode are connected to each other via a conductive material or the like filling the through-hole.

The first element and the second element are not limited and each may be a circuit element provided with an element, a wire, and an electrode. For example, the first element and the second element each may be a sensor circuit element provided with a pixel portion (pixel region) or a circuit element mounted with a peripheral circuit portion such as a logic circuit that implements various types of signal processing related to the operation of a solid-state imaging device, for example.

The materials of the electrodes of the first element and the second element and the conductive material are not limited. Conventional electrode materials such as gold, copper, and aluminum may be used.

The cured film may have any thickness and preferably has a thickness of 10 μm or greater and 300 μm or less. When the thickness of the cured film is within the range, the cured film can further exhibit the function as an insulating layer while further reducing misalignment or cracking of electrodes. The thickness of the cured film is more preferably 20 μm or greater, still more preferably 30 μm or greater and is more preferably 200 μm or less, still more preferably 100 μm or less.

The stack A of the present invention preferably includes an inorganic layer between the first element and the second element.

Providing an inorganic layer between the first element and the second element increases insulation, resulting in a stack having better connection reliability. Conventional stacks include an insulating layer made of an inorganic material having a thickness of about 10 to 20 μm, and thus cannot eliminate warping of elements and the stacks, reducing connection reliability. In the present invention, since the insulating layer mainly consists of the cured film, the stack including the inorganic layer with a reduced thickness can prevent warping of the elements and the stack while exhibiting the effect of the inorganic layer.

The material of the inorganic layer is not limited. Examples thereof include SiN, $SiO_2$, and $Al_2O_3$. Preferred among these are SiN and $SiO_2$ because they excel in insulation and heat resistance.

From the standpoint of further increasing the connection reliability of the stack, the inorganic layer preferably has a thickness of 1 nm or greater, more preferably 5 nm or greater, still more preferably 10 nm or greater, while preferably 1 μm or less, more preferably 500 nm or less, still more preferably 100 nm or less.

The stack A of the present invention preferably includes a barrier metal layer on a surface of the through-hole.

The barrier metal layer serves to prevent the conductive material (e.g., Cu atoms in the case of Cu electrode)

filling the through-hole from diffusing into the cured film. The barrier metal layer provided on the surface of the through-hole covers the conductive material filling the through-hole except for the surfaces that contact the electrodes. This can further reduce short circuiting and conduction failure caused by the diffusion of the conductive material into the cured film. The material of the barrier metal layer may be a known material such as tantalum, tantalum nitride, titanium nitride, silicon oxide, or silicon nitride.

The barrier metal layer may have any thickness. From the standpoint of further increasing the connection reliability of the stack, the barrier metal layer more preferably has a thickness of 1 nm or greater, still more preferably 10 nm or greater, while more preferably 100 nm or less, still more preferably 50 nm or less.

FIG. 1 is a schematic view of an embodiment of the stack A of the present invention. As shown in FIG. 1, in the stack A of the present invention, a first element 1 including electrodes 3 and a second element 2 including electrodes 3 are bonded to each other through cured films 4. The electrodes 3 on the first element 1 and the electrodes 3 on the second element 2 are electrically connected to each other via a conductive material filling through-holes 5 formed in the cured films 4. Conventional stacks include a hard inorganic material in place of the cured films 4, as an insulating layer. Conventional stacks thus cannot eliminate warping of the elements or the stack by stress relaxation and are more likely to have misalignment or cracking of electrodes. The present invention, which uses a flexible organic compound in the insulating layer, can eliminate warping of the elements and the stack and thus reduce misalignment or cracking of electrodes.

FIG. 2 is a schematic view of an embodiment of the stack A of the present invention. In the embodiment in FIG. 2, inorganic layers 6 are formed between the cured films 4, increasing insulation. The inorganic layers 6 may be far thinner than insulating layers of conventional stacks, and thus do not hinder the elimination of warping of the elements or the stack. Although in FIG. 2 the inorganic layers 6 are formed between the cured films 4, they may be formed on the first element 1 and the second element 2. Although in FIG. 2 the inorganic layers 6 are formed on the respective cured films 4 on the first element 1 side and the second element 2 side, an inorganic layer 6 may be formed on only one of the cured films 4. In the embodiment in FIG. 2, barrier metal layers 7 are formed on the surfaces of the through-holes 5. Forming barrier metal layers 7 on the surfaces of the through-holes 5 makes it difficult for the conductive material filling the through-holes 5 to diffuse into the cured films 4, and thus can further reduce short circuiting and conduction failure.

Examples of the method for producing the stack A of the present invention include a method of producing a stack, including the steps of: forming cured films by forming a film of the resin composition of the present invention on a surface of a first element including an electrode, the surface being a surface on which the electrode is formed, and a film of the resin composition on a surface of a second element including an electrode, the surface being a surface on which the electrode is formed, and curing the films; forming a through-hole in each of the cured films; filling the through-holes with a conductive material; forming bonding electrodes by polishing the surface of the first element on the side where the through-hole is filled with the conductive material and the surface of the second element on the side where the through-hole is filled with the conductive material; and bonding the first element on which the bonding electrode is formed and the second element on which the bonding electrode is formed such that the bonding electrodes are bonded to each other. The present invention also encompasses such a method for producing a stack.

The method for producing a stack of the present invention starts with the step of forming cured films by forming a film of the resin composition of the present invention on a surface of a first element including an electrode, the surface being a surface on which the electrode is formed, and a film of the resin composition on a surface of a second element including an electrode, the surface being a surface on which the electrode is formed, and curing the films.

The first element including an electrode, the second element including an electrode, and the resin composition may be the same as the first element including an electrode and the second element including an electrode in the stack of the present invention and the resin composition of the present invention. In the case of the resin composition of the present invention that contains a solvent, the step of forming the cured films is performed after forming films of the resin composition of the present invention and removing the solvent by drying.

The film forming method is not limited and may be a conventionally known method such as spin coating.

The conditions for removing the solvent by drying are not limited. From the standpoint of reducing the residual solvent and improving the heat resistance of the cured films, heating is preferably performed at a temperature of 70°C or higher, more preferably 100°C or higher and preferably 250°C or lower, more preferably 200°C or lower for, for example, 30 minutes, more preferably about one hour.

The curing conditions are not limited. From the standpoint of allowing the curing reaction to sufficiently proceed and further improving heat resistance, heating is preferably performed at a temperature of preferably 200°C or higher, more preferably 220°C or higher and preferably 400°C or lower, more preferably 300°C or lower for, for example, one hour or longer, more preferably about two hours or longer. The upper limit of the heating time is not limited. From the standpoint of reducing thermal decomposition of the cured films, the upper limit is preferably three hours or shorter.

The method for producing a stack of the present invention subsequently conducts the step of forming a through-hole in each cured film.

The through-hole may be patterned. The method for forming the through-hole is not limited. The through-hole can be formed by laser irradiation such as $CO_2$ laser irradiation or etching. When a different layer is formed on an electrode

surface of an element, the through-hole is formed to extend through the different layer as well as the cured film so that the electrode surface of the element is exposed.

Then, the method for producing a stack of the present invention conducts the step of forming an inorganic layer and/or a barrier metal layer, as necessary.

The inorganic layer and the barrier metal layer may be the same as those in the stack of the present invention. The inorganic layer and the barrier metal layer can be formed by sputtering or vapor deposition, for example.

The step of forming an inorganic layer is preferably performed before and/or after the step of forming the cured films. The barrier metal layer is preferably formed after the step of forming a through-hole.

Thereafter, the method for producing a stack of the present invention conducts the step of filling each through-hole with a conductive material. The method of filling the through-hole with the conductive material may be plating, for example.

The conductive material may be the same as the conductive material in the stack of the present invention.

Next, the method for producing a stack of the present invention conducts the step of forming bonding electrodes by polishing the surfaces of the first element and the second element each on the sides where the through-hole is filled with the conductive material.

Removing the conductive material on undesired portions by polishing forms a bonding electrode that connects the electrodes formed on the two elements. The polishing preferably planarizes and removes the layer formed of the conductive material until the cured film is exposed or until the inorganic layer, if present, is exposed.

The method for polishing is not limited and may be a chemical mechanical polishing method, for example.

The present invention also encompasses a method for producing an element including a bonding electrode, including the steps of: forming a cured film by forming a film of the resin composition of the present invention on a surface of an element including an electrode, the surface being a surface on which the electrode is formed, and curing the film; forming a through-hole in the cured film; filling the through-hole with a conductive material; forming a bonding electrode by polishing the surface of the element.

The element including a bonding electrode is a component used for forming a stack by bonding it to another element including a bonding electrode such that the bonding electrodes between the elements are bonded to each other. The descriptions of the element, the cured film, the resin composition, and other structures and the steps are the same as the descriptions of the resin composition, the stack, and the method for producing a stack of the present invention.

Next, the method for producing a stack of the present invention conducts the step of bonding the first element on which the bonding electrode is formed and the second element on which the bonding electrode is formed such that the bonding electrodes are bonded to each other.

The resin composition of the present invention can provide cured films with planar bonding surfaces because, even when the elements have irregularities on the surface, the composition can fill the irregularities. Such cured films enable secure bonding and can enhance the electrical connection reliability.

The first element and the second element may be bonded by a method of connecting the electrodes and the bonding electrodes by melting them by heat treatment. The heat treatment is typically performed at about 400°C for about four hours.

The stack of the present invention may be used in any application. Since the stack has high electrical connection reliability and can particularly reduce warping or cracking of the elements or the stack even when thin elements are bonded to each other, the stack can be suitably used as a stack that constitutes a semiconductor device or an imaging device.

The present invention also encompasses such a semiconductor device including the stack of the present invention and such an imaging device including the stack of the present invention.

The cured film of the present invention can suitably be used as an insulating layer in a stack that has a structure equal or similar to the structure of the stack A. The cure film can also suitably be used as an insulating layer in a stack that has a structure in which a supporting substrate is stacked on an element including a plurality of chips on the surface with the chips.

The present invention also encompasses such a stack that includes a supporting substrate, a third element, and the cured film of the present invention between the supporting substrate and the third element, wherein the third element has a first surface and a second surface, the first surface includes a plurality of chips, and the cured film is stacked on the first surface side (hereinafter the stack is also referred to as a stack B).

The stack B of the present invention includes the cured film of the present invention between the supporting substrate and the third element.

Examples of the supporting substrate include glass and monocrystalline silicon. The third element is as described above regarding the first element and the second element. The cured film is also as described above.

The third element has the first surface and the second surface. The first surface includes a plurality of chips. The cured film is stacked on the first surface side.

The plurality of chips increase irregularities of the surface with the chips of the third element. In the present invention, the resin composition to form the cured film can sufficiently fill gaps in even a surface with large irregularities and

therefore can planarize a bonding surface. Thus, the reliability of connection with the supporting substrate can be enhanced, and also warping and cracking of elements can be suppressed. The number of chips may be any number of two or more.

The stack B of the present invention preferably includes an inorganic layer between the supporting substrate and the cured film.

Further providing an inorganic layer between the supporting substrate and the cured film can further enhance insulation. The inorganic layer may be the same as the inorganic layer in the stack A of the present invention.

Preferably, the stack B of the present invention further includes a fourth element on the second surface of the third element, and the third element and the fourth element are electrically connected to each other.

In the stack B of the present invention, the third element which has a surface with large irregularities due to the chips is sufficiently connected to the supporting substrate by the cured film of the present invention. Thus, warping and cracking of the third element can be suppressed, which also suppresses warping and cracking of the fourth element stacked on the third element. Consequently, misalignment or cracking of electrodes between the elements can be suppressed, thereby enhancing the electrical connection reliability.

The fourth element may be the same as or similar to any of the first to third elements.

FIG. 3 is a schematic view of an embodiment of the stack B of the present invention. As shown in FIG. 3, the stack B of the present invention includes a plurality of chips 9 stacked on a first surface of a third element 8, the chips being electrically connected to the third element 8. The stack B includes a fourth element 10 stacked on a second surface opposite to the first surface, the fourth element 10 being electrically connected to the third element 8. The first surface of the third element 8 and a supporting substrate 11 are stacked via a cured film 4. Since the stack B of the present invention includes the cured film of the resin composition of the present invention, irregularities between the chips 9 and the supporting substrate 11 can be sufficiently filled to planarize the bonding surface. The stack B can thus eliminate warping and connection defects of the elements and chips, thereby imparting high electrical connection reliability between the elements.

FIG. 4 is a schematic view of an embodiment of the stack B of the present invention. The embodiment in FIG. 4 includes, in addition to the components of the embodiment in FIG. 3, an inorganic layer 6 between the cured film 4 and the supporting substrate 11, further increasing insulation. The inorganic layers 6 may be far thinner than insulating layers of conventional stacks, and do not hinder the elimination of warping of the elements or the stack.

The use of the stack B of the present invention is not limited and the stack B is suitably for use in an imaging device or a semiconductor device, as is the stack A.

The present invention also encompasses an imaging device and a semiconductor device each including the stack B of the present invention.

- Advantageous Effects of Invention

The present invention can provide a resin composition that excels in heat resistance and flexibility and can planarize bonding surfaces of elements even when the elements have irregularities on the surfaces, thus imparting high electrical connection reliability between the elements, as well as a cured film formed using the resin composition, a stack including the cured film, an imaging device including the stack, a semiconductor device including the stack, a method for producing the stack, and a method for producing an element including a bonding electrode for use in production of the stack.

## BRIEF DESCRIPTION OF DRAWINGS

FIG. 1 is a schematic view of an embodiment of the stack of the present invention.
FIG. 2 is a schematic view of an embodiment of the stack of the present invention.
FIG. 3 is a schematic view of an embodiment of the stack of the present invention.
FIG. 4 is a schematic view of an embodiment of the stack of the present invention.

## DESCRIPTION OF EMBODIMENTS

Embodiments of the present invention are more specifically described in the following with reference to examples. The present invention, however, is not limited to these examples.

(1) Production of organosilicon compound a

A reaction vessel equipped with a reflux condenser, a thermometer, and a dropping funnel was charged with 320 g of phenyltrimethoxysilane (available from Tokyo Chemical Industry Co., Ltd., molecular weight 198.29), 8.8 g of sodium hydroxide, 6.6 g of water, and 263 mL of 2-propanol. Heating was started under a nitrogen gas flow with stirring. Stirring was continued for six hours from the start of reflux, and the mixture was then left to stand overnight at room temperature. The reaction mixture was transferred into a filter and filtered by pressurization with nitrogen gas. The obtained solid was washed with 2-propyl alcohol once, filtered, and then dried at 80°C under reduced pressure to give 330 g of a colorless solid (DD-ONa) .

Next, a reaction vessel equipped with a reflux condenser, a thermometer, and a dropping funnel was charged with 20 g of cyclopentyl methyl ether, 2.4 g of 2-propanol, 14 g of ion-exchanged water, and 7.25 g of trichloromethylsilane (available from Tokyo Chemical Industry Co., Ltd., molecular weight 149.48). They were stirred under a nitrogen atmosphere at room temperature. Subsequently, 8 g of the obtained compound (DD-ONa) and 20 g of cyclopentyl methyl ether were put into the dropping funnel, made into a slurry, and added dropwise into the reactor over 30 minutes. Stirring was continued for 30 minutes after the termination of the dropwise addition. After the reaction, stirring was terminated, and the mixture was left to stand to be separated into an organic layer and an aqueous layer. The organic layer was neutralized by washing with water, passed through a membrane filter to remove impurities, and concentrated under reduced pressure at 60°C using a rotary evaporator to give a 9.5 g of a colorless solid. This colorless solid was washed with 10 g of methyl acetate and dried under reduced pressure, whereby 6.2 g of a colorless, powdery solid (DD(Me)-OH) was obtained.

A condenser, a mechanical stirrer, a Dean-Stark trap, an oil bath, and a thermometer protecting tube were attached to a 100-mL flask. The air inside the flask was purged with nitrogen. The flask was charged with 5.0 g of the (DD(Me)-OH), 2.5 g of octamethylcyclotetrasiloxane (D4), 0.5 g of RCP-160M (strongly acidic cation exchange resin, available from Mitsubishi Chemical Corporation: water content 23.4 mass%), and 51.0 mL of dehydrated toluene, followed by refluxing for one hour to extract 22.4 mL of toluene and 0.12 g of water contained 23.4 mass% in the RCP-160M. After refluxing, the content of the flask was cooled to 80°C, and 0.55 g of pure water was added thereto, followed by aging at 80°C. Equilibrium was reached in five hours. The resulting content was cooled to room temperature, and the RCP-160M was filtered out. The resulting filtrate was washed once with water. Thereafter, the solvent and low-boiling components of the filtrate were removed by distillation. The resulting crude product was purified by reprecipitation with heptane, thereby obtaining an organosilicon compound (organosilicon compound a, weight average molecular weight 36,000) having a structure represented by the following formula (8) with m being 30 and n (DMS chain number) being 4 on average.

[Chem. 7]

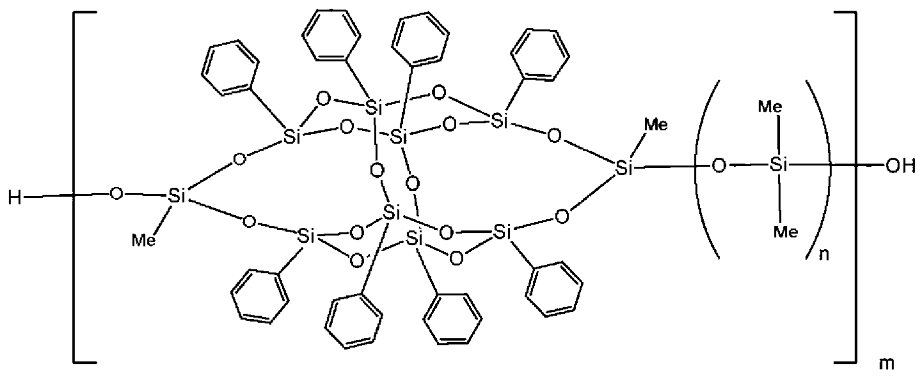

(8)

(2) Preparation of organosilicon compound b

SST-3PM4 available from Gelest was used as an organosilicon compound b. Here, SST-3PM4 is an organosilicon compound not satisfying the formula (1).

(3) Production of resin A (heat resistant additive)

A reaction vessel equipped with a stirring device, a water separator, a thermometer, and a nitrogen gas introduction device was charged with 10.00 g of 4,4'-(hexafluoroisopropylidene)diphthalic anhydride (available from Tokyo Chemical Industry Co., Ltd., molecular weight 444.24), which is a tetracarboxylic dianhydride, and 92.72 g of anisole. The solution in the reaction vessel was heated to 60°C. Subsequently, 7.573 g of PAM-E (available from Shin-Etsu

Chemical Co., Ltd., molecular weight 280.51), which is an aromatic diamine, was added into the reaction vessel. A Dean-Stark trap and a condenser were attached to a flask. The mixture was heated and refluxed at 100°C for one hour and further refluxed at 170°C for four hours, whereby an imide compound having an amine at both terminals was obtained. After cooling, citraconic anhydride (available from Tokyo Chemical Industry Co., Ltd., molecular weight 112.08) was added and stirred with heating at 120°C for 10 minutes, and further heated at 170°C for 20 minutes, whereby a compound (resin A, weight average molecular weight 9,000) having an imide structure of the following formula (9) was obtained.

[Chem. 8]

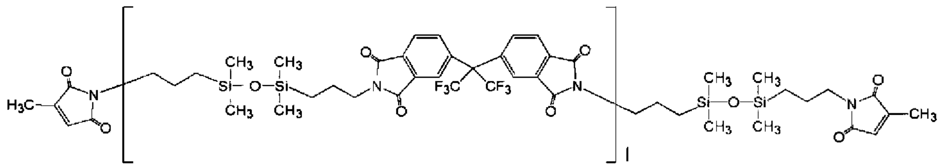

(9)

In the formula, 1 represents the number of repeating units.

(4) Preparation of modifier

The following compounds were prepared as modifiers.

Modifier A (BYK-320, available from BYK-Chemie): polymethylalkylsiloxane having a polyether-modified group, molecular weight 22,000
Modifier B (BYK-325N, available from BYK-Chemie): polymethylalkylsiloxane having a polyether-modified group, molecular weight 17,000
Modifier C (KP-341, available from Shin-Etsu Chemical Co., Ltd.): silicone compound having a polyether-modified group, molecular weight 18,000
Modifier D (KP-112, available from Shin-Etsu Chemical Co., Ltd.): silicone compound having a polyether-modified group, molecular weight 20,000
Modifier E (BYK-326, available from BYK-Chemie): polymethylalkylsiloxane having a polyether-modified group, molecular weight 25,000
Modifier F (BYK-307, available from BYK-Chemie): polydimethylsiloxane having a polyether-modified group, molecular weight 31,000
Modifier G (BYK-330, available from BYK-Chemie): polydimethylsiloxane having a polyether-modified group, molecular weight 19,000
Modifier H (BYK-327, available from BYK-Chemie): polydimethylsiloxane having a polyether-modified group, molecular weight 6,700
Modifier I (BYK-310, available from BYK-Chemie): polymethylalkylsiloxane having a polyether-modified group, molecular weight 4,400
Modifier J (BYK-322, available from BYK-Chemie): polymethylalkylsiloxane having an aralkyl-modified group, molecular weight 12,000
Modifier K (BYK-323, available from BYK-Chemie): polymethylalkylsiloxane having an aralkyl-modified group, molecular weight 27,000
Modifier L (KF-96-100cs, available from Shin-Etsu Chemical Co., Ltd.): silicone oil, molecular weight 12,000
Modifier M (KF-96-1000cs, available from Shin-Etsu Chemical Co., Ltd.): silicone oil, molecular weight 34,000
Modifier N: fluorine surfactant, molecular weight 14,000
Modifier O (BYK-394, available from BYK-Chemie): polyacrylate surface modifier, molecular weight 7,000

(5) Measurement of thermal weight loss of modifier

Using a simultaneous differential thermogravimetric analyzer (TG-DTA; STA7200, available from Hitachi High-Technologies Corporation), the modifiers were each heated from 25°C to 300°C in the air at a temperature increase rate of 10°C/min and maintained for one hour. After the modifier was maintained for one hour, it was heated to 400°C at a temperature increase rate of 10°C/min and then maintained at 400°C for three hours. The thermal weight loss was calculated from the weight when the temperature first reached 400°C and the weight three hours after being maintained at 400°C among the weights at temperatures in the process.

(Example 1)

Cyclopentanone as a solvent was added to 100 parts by weight of an organosilicon compound, 0.5 parts by weight of the modifier A, 3.2 parts by weight of a crosslinking agent (Silicate MS-51, available from Mitsubishi Chemical Corporation), 0.2 parts by weight of a catalyst (ZC-162, available from Matsumoto Fine Chemical Co., Ltd.), and 1.0 parts by weight of the resin A (heat resistant additive) such that the resulting composition had a viscosity of 1,200 cP, whereby a resin composition was obtained.

(Examples 2 to 12, Comparative Examples 1 to 8)

Resin compositions were obtained as in Example 1, except that the types and amounts of the organosilicon compound, the modifier, and the solvent were changed according to the formulations shown in Table 1 or 2.

The viscosity of all the resin compositions in the examples and comparative examples was controlled to be 1,200 cP.

<Physical properties>

The obtained resin compositions were subjected to the following measurements. Tables 1 and 2 show the results.

(Measurement of contact angle)

The organosilicon compound and 1 part by weight of the modifier relative to 100 parts by weight of the organosilicon compound were added to ethyl benzoate to prepare a sample having a viscosity of 45 cP at 25°C. The sample was dropped onto a silicon wafer using a contact angle measuring device (full automatic contact angle meter DMo-702, available from Kyowa Interface Science Co., Ltd.) to measure the contact angle of the sample on the silicon wafer. The modifiers in Comparative Examples 4 and 5 were not dissolved in the solvents. Thus, the measurement of the contact angle and the below-described measurements as well as evaluations were omitted.

(Measurement of surface free energy)

A solution of each of the resin compositions in Tables 1 and 2 was used for the following measurement. Six grams of the solution was dropped onto a central portion of an 8-inch silicon wafer at room temperature. The dropped resin composition was applied to the silicon wafer (surface roughness < 0.1 μm) using a spin coater (ACT-400II, available from ACTIVE) at 1,500 rpm for 10 seconds. The solution-applied wafer was heated at 125°C for 10 minutes to remove the solvent by drying. Subsequently, the wafer was heated at 300°C for one hour to obtain a cured resin film with a thickness of 35 um. Water and diiodomethane were dropped onto the obtained cured resin film using a contact angle measuring device (full automatic contact angle meter DMo-702, available from Kyowa Interface Science Co., Ltd.). The contact angles of the liquids on the cured resin film were measured to determine a dispersion energy, $\gamma^d$, and an interaction energy, $\gamma^h$. The surface free energy, y, was calculated from the sum of the $\gamma^d$ and the $\gamma^h$.

<Evaluation>

The resin compositions obtained in the examples and the comparative examples were evaluated as follows. Tables 1 and 2 show the results.

(Evaluation of film cracking)

Six grams of a solution obtained in the same manner as in the measurement of surface free energy was dropped onto a central portion of an 8-inch silicon wafer at room temperature. The dropped resin composition was applied to the silicon wafer (surface roughness < 0.1 μm) using a spin coater (ACT-400II, available from ACTIVE) at 1,500 rpm for 10 seconds. The solution-applied wafer was heated at 125°C for 10 minutes to remove the solvent by drying, while controlling the duration of the rotation of the spin coater such that the resulting dried resin composition had a thickness of 35 μm. Further, the dried resin composition was cured by heating at 300°C for one hour. After the cured film was cooled to room temperature, the face (surface) with the cured film was observed to evaluate the occurrence of film cracking.

(Evaluation of 1% thermal weight loss temperature)

A cured film was obtained in the same manner as in the evaluation of film cracking. The cured film was heated

using a simultaneous differential thermogravimetric analyzer (TG-DTA; STA7200, available from Hitachi High-Technologies Corporation) under 200 mL/min nitrogen flow at a temperature increase rate of 10°C/min. The temperature at which the weight loss reached 1% was measured.

(Evaluation of groove-filling properties)

Six grams of a solution obtained in the same manner as in the measurement of surface free energy was dropped onto a central portion of an 8-inch silicon wafer that had grooves each with a depth of 10 μm and a width of 300 μm at intervals of 40 mm. The dropped solution was applied to the silicon wafer (surface roughness of parts other than the grooves < 0.1 μm) to form a film using a spin coater (ACT-400II, available from Active, Ltd.). The solution-applied wafer was heated at 125°C for 10 minutes to remove the solvent by drying. At this time, the duration of the rotation of the spin coater was adjusted such that the resulting dried resin composition had a thickness of 35 μm. Further, the dried resin composition was cured by heating at 300°C for one hour. The groove portions of the silicon wafer on the surface of the heat-cured product were observed using a laser microscope (OLS4100, available from Olympus Corporation), and the depths of the groove portions were measured. The percentage (calculated by the formula below) obtained by dividing the depth of each groove measured with the laser microscope by the original depth (10 μm) of the groove in the wafer was determined as the amount of indentation (%). The groove-filling properties (planarization properties) were evaluated based on the following criteria. The numerical values in the tables are the amounts of indentation (%).

$$\text{Amount of indentation (\%)} = (\text{Groove depth } (\mu m) \text{ after application and curing of resin composition})/10\ (\mu m) \times 100$$

o (Good): Amount of indentation of less than 7%
Δ (Fair): Amount of indentation of 7% or greater and less than 10%
× (Poor): Amount of indentation of 10% or greater

[Table 1]

| | | | | Example 1 | Example 2 | Example 3 | Example 4 | Example 5 | Example 6 | Example 7 | Example 8 | Example 9 | Example 10 | Example 11 | Example 12 |
|---|---|---|---|---|---|---|---|---|---|---|---|---|---|---|---|
| Formulation | Modifier | Type | - | A | B | C | D | E | F | G | H | I | A | A | A |
| | | Substituent, etc. | - | Polyether-modified group | Polyether-modified group | Polyether-modified group | Polyether-modified group | Polyether-modified group | Polyether-modified group | Polyether-modified group | Polyether-modified group | Polyether-modified group | Polyether-modified group | Polyether-modified group | Polyether-modified group |
| | | Molecular weight | - | 22000 | 17000 | 18000 | 20000 | 25000 | 31000 | 19000 | 6700 | 4400 | 22000 | 22000 | 22000 |
| | | Thermal weight loss | % | 1.9 | 3.8 | 1.6 | 1.9 | 4.6 | 6.6 | 3.5 | 1.3 | 2 | 1.9 | 1.9 | 1.9 |
| | | Amount | parts by weight | 0.5 | 0.5 | 0.5 | 0.5 | 0.5 | 0.5 | 0.5 | 0.5 | 0.5 | 0.5 | 0.1 | 1 |
| | Organosilicon compound | Type | | a | a | a | a | a | a | a | a | a | a | a | a |
| | | Amount | parts by weight | 100 | 100 | 100 | 100 | 100 | 100 | 100 | 100 | 100 | 100 | 100 | 100 |
| | Solvent | Cyclopentanone | | ○ | ○ | ○ | ○ | ○ | ○ | ○ | ○ | ○ | - | ○ | ○ |
| | | Ethyl benzoate | | - | - | - | - | - | - | - | - | - | o | - | - |
| Physical **properties** | Contact angle | | ° | 14.42 | 9.1 | 15.0 | 11.6 | 9.42 | 18.4 | 16.7 | 9.28 | 14.86 | 14.42 | 14.42 | 14.42 |
| | Surface energy | Dispersion energy $\gamma^d$ | $mJ/m^2$ | 32.76 | 29.67 | 29.3 | 30.4 | 29.96 | 27.02 | 28.4 | 28.12 | 29.15 | 32.81 | 27.9 | 29.4 |
| | | Interaction energy $\gamma^h$ | $mJ/m^2$ | 0.37 | 0.47 | 1.0 | 0.8 | 0.47 | 0.73 | 0.91 | 0.98 | 0.81 | 0.67 | 0.6 | 0.5 |
| | | Surface free energy $\gamma$ | $mJ/m^2$ | 33.13 | 30.14 | 30.29 | 31.22 | 30.43 | 27.75 | 29.31 | 29.1 | 29.96 | 33.48 | 28.5 | 29.9 |
| Evaluation | Film cracking | | Evaluation | Not occurred | Not occurred | Not occurred | Not occurred | Not occurred | Not occurred | Not occurred | Not occurred | Not occurred | Not occurred | Not occurred | Not occurred |
| | 1% Thermal weight loss temperature | | °C | 467 | 477 | 474.0 | 481.0 | 484 | 468 | 472 | 474 | 471 | 467 | 468 | 461 |
| | Groove-filling properties | | % | 6.84 | 7.92 | 8.43 | 9.08 | 9.47 | 8.81 | 8.72 | 8.92 | 9.59 | 6.97 | 8.8 | 9.1 |
| | | | Evaluation | ○ | Δ | Δ | Δ | Δ | Δ | Δ | Δ | Δ | ○ | Δ | Δ |

[Table 2]

| | | | | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|---|---|
| Formulation | Modifier | Type | - | None | J | K | L | M | N | O | A |
| | | Substituent, etc. | - | - | Aralkyl-modified group | Aralkyl-modified group | Silicone oil | Silicone oil | Fluorine type | Polyacrylate type | Polyether-modified group |
| | | Molecular weight | - | - | 12000 | 27000 | 12000 | 34000 | 14000 | 7000 | 22000 |
| | | Thermal weight loss | % | - | 47.9 | 61.4 | 22.9 | 11.9 | 2.9 | 13 | 1.9 |
| | | Amount | parts by weight | 0.5 | 0.5 | 0.5 | 0.5 | 0.5 | 0.5 | 0.5 | 0.5 |
| | Organosilicon compound | Type | - | a | a | a | a | a | a | a | b |
| | | Amount | parts by weight | 100 | 100 | 100 | 100 | 100 | 100 | 100 | 100 |
| | Solvent | Cyclopentanone | | ○ | ○ | ○ | ○ | ○ | ○ | ○ | ○ |
| | | Ethyl benzoate | | - | - | - | - | - | - | - | - |
| Physical properties | Contact angle | | ° | 23.5 | 9.14 | 8.88 | × Insoluble | × Insoluble | 30.54 | 9.9 | 22.1 |
| | Surface energy | Dispersion energy $\gamma^d$ | mJ/m2 | 29.96 | 30.7 | 29.55 | - | - | 23.36 | 29.38 | 38.3 |
| | | Interaction energy $\gamma^h$ | $mJ/m^2$ | 0.47 | 0.92 | 0.74 | - | - | 1.48 | 0.52 | 1.6 |
| | | Surface free energy $\gamma$ | mJ/m2 | 30.43 | 31.62 | 30.29 | - | - | 33.84 | 29.9 | 39.9 |
| Evaluation | Film cracking | | Evaluation | Not occurred | Occurred | Occurred | - | - | Not occurred | Occurred | Occurred |
| | 1% Thermal weight loss temperature | | °C | 461 | 470 | 466 | - | - | 463 | 460 | 401 |
| | Groove-filling properties | | % | 11.34 | 8.31 | 8.66 | - | - | 11 | 10 | 13 |
| | | | Evaluation | × | Δ | Δ | - | - | × | × | × |

INDUSTRIAL APPLICABILITY

The present invention can provide a resin composition that excels in heat resistance and flexibility and can planarize bonding surfaces of elements even when the elements have irregularities on the surfaces, thus imparting high electrical connection reliability between the elements, as well as a cured film formed using the resin composition, a stack including the cured film, an imaging device including the stack, a semiconductor device including the stack, a method for producing the stack, and a method for producing an element including a bonding electrode for use in production of the stack.

REFERENCE SIGNS LIST

1 first element
2 second element
3 electrode
4 cured film
5 through-hole
6 inorganic layer
7 barrier metal layer
8 third element
9 chip
10 fourth element
11 supporting substrate

**Claims**

1. A resin composition comprising:

an organosilicon compound; and
a modifier,
the modifier having a thermal weight loss of 10% or less between before and after being maintained at 400°C for three hours when the modifier alone is heated from room temperature to 300°C in the air at a temperature increase rate of 10°C/min, maintained for one hour, then heated to 400°C at a temperature increase rate of 10°C/min, and maintained at 400°C for three hours,
a sample, prepared by adding the organosilicon compound and 1 part by weight of the modifier relative to 100 parts by weight of the organosilicon compound to ethyl benzoate such that the sample has a viscosity at 25°C of 45 cP, having a contact angle of 9° or greater and 20° or less on a silicon wafer when the sample is dropped onto the silicon wafer.

2. The resin composition according to claim 1,

wherein the resin composition further comprises a solvent, and
the resin composition forms a cured resin film having a surface free energy of 27 mJ/$m^2$ or greater, the cured resin film being obtained by spin coating the resin composition as a solution with a viscosity of 1,200 cP in the solvent on a silicon wafer at 1,500 rpm for 10 seconds, removing the solvent by drying, and curing the resulting product at 300°C for one hour into a cured resin film with a thickness of 10 μm or greater.

3. The resin composition according to claim 1 or 2, comprising a metal catalyst, a crosslinking agent, and a heat resistant additive.

4. The resin composition according to any one of claims 1 to 3,

wherein the organosilicon compound has a structure represented by the following formula (1):

[Chem. 1]

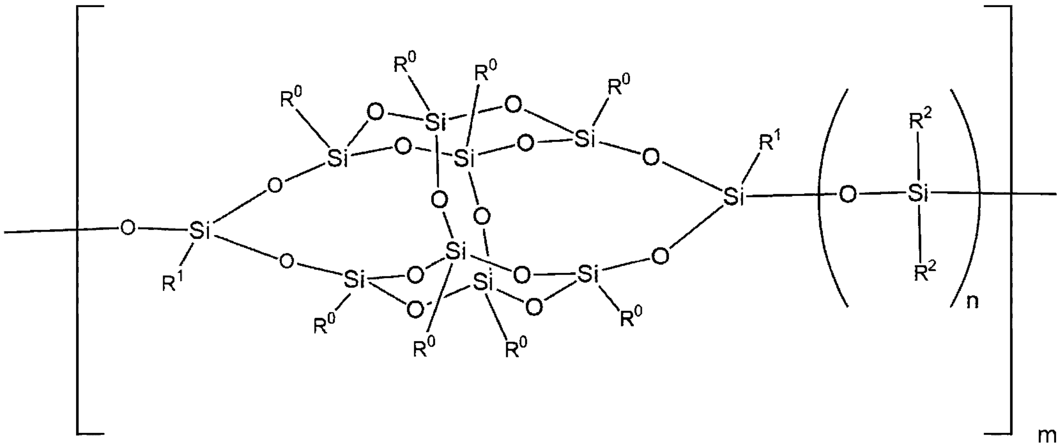

(1)

wherein $R^0$s, $R^1$s, and $R^2$s each independently represent a linear, branched, or cyclic aliphatic group, an aromatic group, or hydrogen; the aliphatic group and the aromatic group each optionally have a substituent; and m and n each represent an integer of 1 or greater.

**5.** The resin composition according to any one of claims 1 to 4,
wherein the modifier has a polyether-modified group.

**6.** The resin composition according to any one of claims 1 to 5,
wherein the resin composition contains the modifier in an amount of 0.01 parts by weight or more and 10 parts by weight or less relative to 100 parts by weight of the organosilicon compound.

**7.** The resin composition according to any one of claims 1 to 6,
wherein the modifier has a weight average molecular weight of 4,000 or greater and 30,000 or less.

**8.** The resin composition according to claim 2,
wherein a cured product obtained after removing the solvent by drying and then curing the resulting product at 300°C for one hour has a 1% weight loss temperature of 460°C or higher.

**9.** The resin composition according to any one of claims 1 to 8,
wherein the resin composition is used to form an insulating layer on a surface with irregularities of an element having a surface with irregularities.

**10.** A resin composition comprising:

an organosilicon compound; and
a modifier,
the organosilicon compound having a structure represented by the following formula (1):

[Chem. 2]

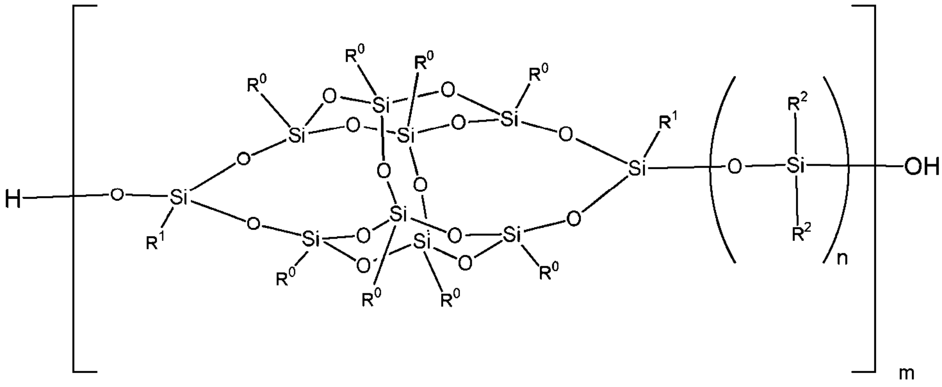

(1)

wherein $R^0$s, $R^1$s, and $R^2$s each independently represent a linear, branched, or cyclic aliphatic group, an aromatic group, or hydrogen; the aliphatic group and the aromatic group each optionally have a substituent; and m and n each represent an integer of 1 or greater,
the modifier having a polyether-modified group.

**11.** A cured film formed using the resin composition according to any one of claims 1 to 10.

**12.** A stack comprising:

a first element including an electrode;
a second element including an electrode; and
the cured film according to claim 11 between the first element and the second element,
the electrode of the first element and the electrode of the second element being electrically connected to each other via a through-hole extending through the cured film.

**13.** The stack according to claim 12, comprising an inorganic layer between the first element and the second element.

**14.** The stack according to claim 12 or 13, comprising a barrier metal layer on a surface of the through-hole.

**15.** An imaging device comprising the stack according to any one of claims 12 to 14.

**16.** A semiconductor device comprising the stack according to any one of claims 12 to 14.

**17.** A method for producing a stack, comprising the steps of:

forming cured films by forming a film of the resin composition according to any one of claims 1 to 10 on a surface of a first element including an electrode, the surface being a surface on which the electrode is formed, and a film of the resin composition on a surface of a second element including an electrode, the surface being a surface on which the electrode is formed, and curing the films;
forming a through-hole in each of the cured films;
filling each of the through-holes with a conductive material;
forming bonding electrodes by polishing the surface of the first element on the side where the through-hole is filled with the conductive material and the surface of the second element on the side where the through-hole is filled with the conductive material; and
bonding the first element on which the bonding electrode is formed and the second element on which the bonding electrode is formed such that the bonding electrodes are bonded to each other.

**18.** A method for producing an element including a bonding electrode, comprising the steps of:

forming a cured film by forming a film of the resin composition according to any one of claims 1 to 10 on a surface of an element including an electrode, the surface being a surface on which the electrode is formed, and curing the film;

forming a through-hole in the cured film;
filling the through-hole with a conductive material; and
forming a bonding electrode by polishing the surface of the element including the electrode, the surface being on the side where the through-hole is filled with the conductive material.

**19.** A stack comprising:

a supporting substrate;
a third element; and
the cured film according to claim 11 between the supporting substrate and the third element,
the third element having a first surface and a second surface, the first surface including a plurality of chips, the cured film being stacked on the first surface side.

**20.** The stack according to claim 19, comprising an inorganic layer between the supporting substrate and the cured film.

**21.** The stack according to claim 19 or 20,

wherein the stack further comprises a fourth element on the second surface of the third element, and
the third element and the fourth element are electrically connected to each other.

**22.** An imaging device comprising the stack according to any one of claims 19 to 21.

**23.** A semiconductor device comprising the stack according to any one of claims 19 to 21.

FIG.1

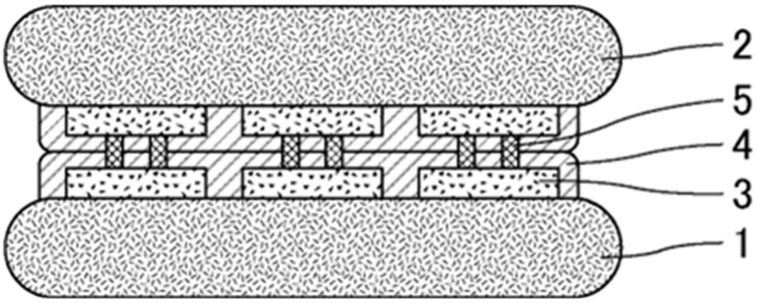


FIG.2

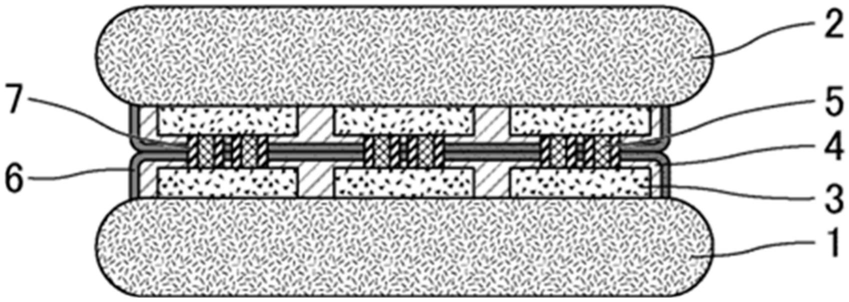


FIG.3

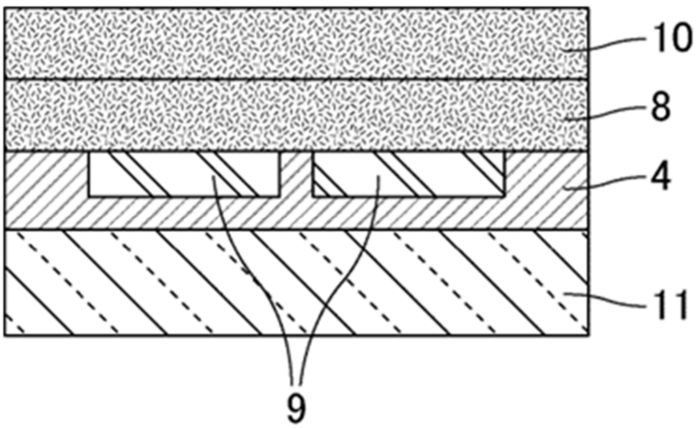

FIG.4

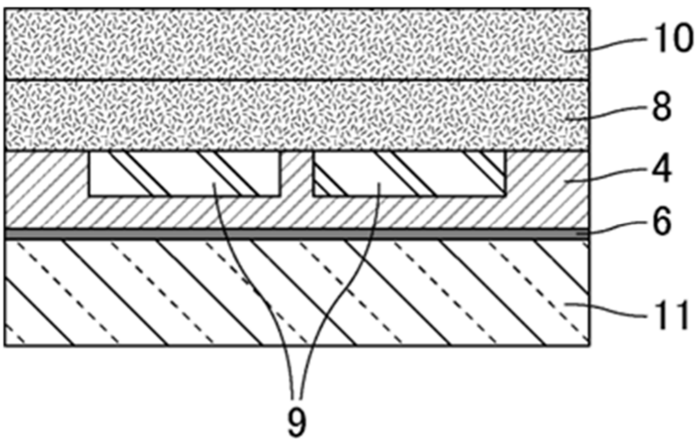

**INTERNATIONAL SEARCH REPORT**

International application No.
**PCT/JP2024/001676**

**A. CLASSIFICATION OF SUBJECT MATTER**

***C08L 83/04***(2006.01)i; ***B32B 27/00***(2006.01)i; ***C08G 77/44***(2006.01)i; ***C08L 83/12***(2006.01)i; ***C08L 101/06***(2006.01)i; ***H01L 21/768***(2006.01)i; ***H01L 23/532***(2006.01)i
FI: C08L83/04; C08L83/12; C08L101/06; C08G77/44; B32B27/00 101; H01L21/90 S

According to International Patent Classification (IPC) or to both national classification and IPC

**B. FIELDS SEARCHED**

Minimum documentation searched (classification system followed by classification symbols)

C08L83/04; B32B27/00; C08G77/44; C08L83/12; C08L101/06; H01L21/768; H01L23/532

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2022/215759 A2 (JNC CORP.) 13 October 2022 (2022-10-13)<br>entire text | 1-23 |
| A | WO 2021/261403 A1 (SEKISUI CHEMICAL CO., LTD.) 30 December 2021 (2021-12-30) | 1-23 |
| A | WO 2022/112662 A1 (BRIGHTPLUS OY) 02 June 2022 (2022-06-02)<br>entire text | 1-23 |
| A | JP 2020-100819 A (TORAY INDUSTRIES, INC.) 02 July 2020 (2020-07-02)<br>entire text | 1-23 |
| P, A | WO 2023/120625 A1 (SEKISUI CHEMICAL CO., LTD.) 29 June 2023 (2023-06-29)<br>entire text | 1-23 |
| P, A | JP 2023-94125 A (SEKISUI CHEMICAL CO., LTD.) 05 July 2023 (2023-07-05)<br>entire text | 1-23 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **19 March 2024** | **02 April 2024** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (July 2022)

**INTERNATIONAL SEARCH REPORT**
**Information on patent family members**

International application No.
**PCT/JP2024/001676**

| Patent document cited in search report | Publication date (day/month/year) | Patent family member(s) | Publication date (day/month/year) |
|---|---|---|---|
| WO 2022/215759 A2 | 13 October 2022 | TW 202313788 A | |
| WO 2021/261403 A1 | 30 December 2021 | US 2023/0245936 A1<br>entire text<br>EP 4169971 A1<br>CN 115244670 A<br>KR 10-2023-0028205 A<br>TW 202204482 A | |
| WO 2022/112662 A1 | 02 June 2022 | JP 2023-551011 A<br>CN 116547248 A | |
| JP 2020-100819 A | 02 July 2020 | (Family: none) | |
| WO 2023/120625 A1 | 29 June 2023 | TW 202336161 A | |
| JP 2023-94125 A | 05 July 2023 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006191081 A